# EUROPEAN PATENT APPLICATION

(11) **EP 3 246 674 A1**
(43) Date of publication of application: **22.11.2017**
(21) Application number: 17466006.8
(22) Date of filing: 07.04.2017
(51) Int. Cl.: G01H 3/08, G01R 31/34

(54) **METHOD FOR DIAGNOSTIC OF MAGNETIC CIRCUITS IN LARGE ELECTRIC MACHINES**

(30) Priority: 19.05.2016 CZ 20160293
(71) Applicant: Monhart Akustik s.r.o., 340 12 Svihov (CZ)
(72) Inventor: MONHART, Frantisek, 340 12 Svihov (CZ)
(74) Representative: Polacek, Jiri

(57) **Abstract**

The present invention concerns diagnostics of magnetic circuits in large non-rotating electric machines and stators in large rotating machines during their operation. In a chosen location and in a pre-determined distance from the case of the machine under measurement, a noise sensor is placed which monitors acoustic pressure or another acoustic quantity as a function of time which are then converted using Fast Fourier Transformation (FFT) from the time domain into the frequency domain. In the resulting spectrogram, characteristic components comprised by even integer multiples of the specified power supply frequency of the electromagnetic circuit are separated from the subharmonic components caused by a mechanical fault, where the latter then become a basis for evaluating the mechanical fault.

## Description

### Technical Field

The present invention relates to diagnostics of magnetic circuits in large non-rotating electric machines and stators in large rotating machines during their operation.

### Background Art

The behaviour of magnetic circuits in large non-rotating electric machines and stators in large rotating machines in operation is often monitored by means of vibration sensors. Using this method, only local variations in the magnetic circuit behaviour are detected; and their number is limited by the number of sensors installed. The choice of locations for attaching these sensors is constrained by the construction of the machine of interest. Furthermore, it may prove difficult to transmit the output signal to the outsize of the machine. This kind of measurement provides nothing more than locally confined information on the state of the magnetic circuit - which is of diverse material composition - and the information therefore does not guarantee reliable identification of the causes of change state. Additional difficulties are related to installation of the vibration sensors, i.e. the small spaces available, the cases involving winding, and the increased electric potential which poses a risk to the safety of operators.

### Disclosure of Invention

The above-mentioned drawbacks are eliminated by diagnostics of magnetic circuits in large non-rotating electric machines and stators in large rotating machines during operation by means of noise measurement. Noise is caused by vibration. This method diagnoses the condition of a magnetic circuit, in which vibration is caused by mechanical faults, indirectly by analyzing the noise generated by vibration. A noise sensor is placed in a chosen location in a predetermined distance from the machine's case to monitor acoustic pressure or another quantity, such as noise intensity, as a function of time. The signal is then converted from the time domain into the frequency domain using Fast Fourier Transformation (FFT), after which the resulting spectrogram is used for separating characteristic frequency components comprising even integer multiples of the specified power supply frequency of the electromagnetic circuit from the sub-harmonic components that arise from mechanical faults, and the latter provide basis for evaluating the mechanical faults, such as loosened parts of the magnetic circuit. The electric machine represents a specific source of noise caused by vibration. The record of the acoustic pressure or another quantity, such as noise intensity, is converted to frequency domain using FFT, producing a spectrogram which comprises characteristic frequency components of the stator electromagnetic field as well as sub-harmonic frequency components that indicate the machine's mechanical fault. The main advantage of this procedure is that the evaluation of the recorded noise signal provides indirect information on the source of vibration that causes the noise. Only after converting the acoustic quantity record by means of FFT into a frequency spectrogram can one analyze the condition of the magnetic circuit of an electric machine.

### Description of Drawings

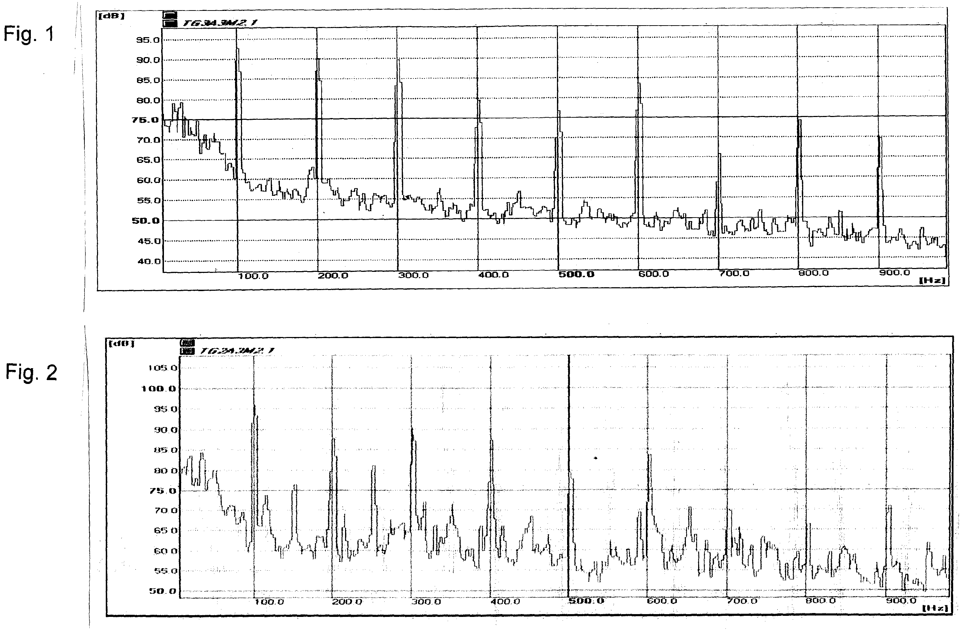

Fig. 1 show a diagram which relies on the fact that the magnetic circuit of an electric machine generates noise whose frequency components are even integer multiples of the power supply frequency of the electromagnetic field, in this case the frequency f = 50 Hz. These frequency components occur when the deformation of the magnetic circuit of the electric machine is caused by elastic deformation of the magnetic circuit of the electric machine while the stiffness of the magnetic circuit is of linear nature. Fig. 2 is a diagram of a magnetic circuit in which stiffness is non-linear due to friction between vibrating parts which generates sub-harmonic components at half the characteristic frequency components of the magnetic circuit.

### Best Mode for Carrying out the Invention

In a certain location in a chosen distance from the case of the running machine under measurement, a noise sensor is placed, such as a microphone or a sound-intensity probe, an acoustic camera or another device. The acoustic pressure or another acoustic quantity is monitored as a function of time. Using FFT, it is converted from the time domain into the frequency domain. The resulting spectrogram contains, above all, characteristic frequency components of electromagnetic origin. These frequency components are even multiples of the frequency of the power supply source of the electromagnetic field. The best mode for carrying out this invention as shown in the attached drawings includes a spectrogram for the power supply frequency of the electromagnetic field of 50 Hz. If the spectrogram contains any sub-harmonic frequency components, they will be found between the characteristic frequency components in Fig. 2. An approximate point of origin of the sub-harmonic frequency component can be located by changing the location of the noise sensor. The closer the noise sensor is to the origin of the sub-harmonic, frequency component, the more pronounced this component becomes in the resulting spectrogram. This mechanical fault is caused by friction between vibrating parts. According to empirical findings, heavy machine parts or those parts which are pressed together by large forces, such as stator core laminations or winding coils in slots, typically emit sub-harmonic components of lower frequencies, less than about 600 Hz. If friction takes place between lightweight parts, such as the shroud panels, liners in stator end windings, and other parts, sub-harmonic components of higher frequencies above approximately 600 Hz are generated. When the location of origin of the sub-harmonic frequency component is known, its cause is identified based on the construction of the electric machine under measurement. By removing the identified cause, the sub-harmonic frequency component is eliminated and the characteristic frequency components begin to stand out in the spectrogram, whereas the sub-harmonic components diminish, as seen in Fig. 1.

Optimum results are achieved with this method when it is applied periodically over a long term and its current outcome can therefore be compared to the earlier ones. The only way to accomplish this is to compare spectrograms constructed with the aid of FFT. It was found in practice that an increase in the level of frequency components by as tittle as 5 dB indicates deterioration of the mechanical condition of the machine. If the level of frequency components increases permanently by more than 10 dB, it is of major importance to identify the cause of such increase and eliminate it promptly, or suspend the operation of the machine.

By recording the levels of acoustic pressure or another quantity, such as noise intensity, as a function of time and converting the resulting profile from the time domain into the frequency domain, one can analyze the actual condition of the magnetic circuit. In the resulting spectrogram, characteristic frequency components represented by even multiples of the specified power supply frequency of the electromagnetic circuit and the sub-harmonic components caused by a mechanical fault are separated. The distribution and magnitudes of both types of components become a basis for evaluating the mechanical fault.

## Claims

1. Diagnostics of magnetic circuits of large non-rotating electric machines and stators of large rotating machines during operation **characterized in that** a noise sensor is installed in a chosen location and in a predetermined distance from the case of the machine under measurement to monitor acoustic pressure or another acoustic quantity as a function of time, where the signal is then converted using Fast Fourier Transformation (FFT) from the time domain into the frequency domain, after which the resulting spectrogram is used for separating characteristic frequencies of the electromagnetic circuit from sub-harmonic components caused by a mechanical fault, where the latter then become a basis for evaluating the mechanical fault.
